(19) **Europäisches Patentamt**
**European Patent Office**
**Office européen des brevets**

(11) **EP 3 879 685 B1**

(12) **EUROPEAN PATENT SPECIFICATION**

(45) Date of publication and mention
of the grant of the patent:
**27.05.2026  Bulletin 2026/22**

(21) Application number: **18939467.9**

(22) Date of filing: **05.11.2018**

(51) International Patent Classification (IPC):
*H02M 1/08* (2006.01)    *H03K 17/687* (2006.01)
*H03K 17/082* (2006.01)   *H03K 17/16* (2006.01)
*H03K 17/0814* (2006.01)  *H02M 1/00* (2006.01)
*H02M 1/32* (2007.01)     *H02M 7/5387* (2007.01)

(52) Cooperative Patent Classification (CPC):
**H02M 1/32; H02M 1/0054; H02M 1/08;**
**H03K 17/08142; H03K 17/163;** H02M 7/5387;
H03K 17/687; H03K 2217/0027; Y02B 70/10

(86) International application number:
**PCT/JP2018/041061**

(87) International publication number:
**WO 2020/095351 (14.05.2020 Gazette 2020/20)**

(54) **GATE DRIVE CIRCUIT AND POWER CONVERSION DEVICE**

GATE-TREIBERSCHALTUNG UND LEISTUNGSUMWANDLUNGSVORRICHTUNG

CIRCUIT D'ATTAQUE DE GRILLE ET DISPOSITIF DE CONVERSION DE PUISSANCE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**15.09.2021  Bulletin 2021/37**

(73) Proprietor: **Mitsubishi Electric Corporation**
**Tokyo 100-8310 (JP)**

(72) Inventors:
• **ASAI, Takamasa**
**Tokyo 102-0073 (JP)**

• **ICHIKI, Masafumi**
**Tokyo 102-0073 (JP)**

(74) Representative: **Hoffmann Eitle**
**Patent- und Rechtsanwälte PartmbB**
**Arabellastraße 30**
**81925 München (DE)**

(56) References cited:
EP-A1- 2 418 774       WO-A1-2015/070344
WO-A1-2016/205929      JP-A- 2018 093 681
JP-A- 2018 520 625     US-A- 4 947 063
US-A1- 2018 159 522

**Description**

Technical Field

The present invention relates to a gate drive circuit configured to perform ON/OFF control of a semiconductor switch, and to a power conversion device including the gate drive circuit.

Background Art

In a semiconductor switch, in particular, a voltage-driven semiconductor switch, a resistance value between two terminals to which and from which a main current is input and output is changed in accordance with a voltage applied to a gate terminal serving as a control terminal so as to change a current flowing through the semiconductor switch. As the voltage-driven semiconductor switch, for example, a power metal oxide semiconductor field effect transistor (MOSFET) and an insulated gate bipolar transistor (IGBT) are known.

The voltage-driven semiconductor switch has a feature of a high-speed switching operation, and is often used in a high-frequency power conversion device. However, as the speed of the switching of the voltage-driven semiconductor switch increases, a surge voltage to be applied to the semiconductor switch also increases due to current interruption at the time of turn-off.

Now, description is given of a generation mechanism of a surge voltage due to the current interruption at the time of turn-off. A pattern of a printed board, a bus bar, or other wiring through which a current flows always has a parasitic inductance component.

Consideration is given to a case in which, when a current flows from a power supply in a forward direction of a turned-on semiconductor switch, the turned-on semiconductor switch is turned off to interrupt the current. In this case, an electromotive voltage proportional to a time change rate of a current is generated in the parasitic inductance of the wiring in a direction of inhibiting the current change. As for the turned-off semiconductor switch, this electromotive voltage is generated in an accumulating direction with respect to the voltage of the power supply. This electromotive voltage is generally called "surge voltage." The forward direction of the semiconductor switch is, for example, in a case of an N-channel MOSFET, a direction from a drain terminal to a source terminal.

The generation of the surge voltage is an unavoidable phenomenon in a device configured to perform ON/OFF control of a current by a semiconductor switch. Therefore, the semiconductor switch is required to have a withstand voltage higher than a voltage obtained by adding a power supply voltage to a surge voltage that may be generated in the device.

However, as the semiconductor switch has a higher withstand voltage relatively, the semiconductor switch has a larger conduction resistance value at the ON time. Therefore, power loss in the semiconductor switch increases, and accordingly a larger heat radiating device is required. Thus, it is better to efficiently use a semiconductor switch having as low a withstand voltage as possible. In other words, it is required to suppress the surge voltage.

In order to suppress the surge voltage, from the above-mentioned generation principle, there is conceivable a solving method of decreasing the time change rate of the current, that is, reducing the switching speed of the semiconductor switch. However, when the switching speed is simply reduced, the switching loss increases. As a result, the power loss in the semiconductor switch increases, and also a larger heat radiating device is required.

There is also a solving method of absorbing the surge voltage by adding a snubber circuit. However, this solving method causes increase in number of components, and thus leads to increase in cost and size of the device.

As described above, the reduction of the surge voltage and the suppression of the power loss of the semiconductor switch generally have a trade-off relationship. Therefore, there has been a demand to reduce the surge voltage while suppressing the increase in switching loss.

As the related art for solving such a problem, for example, the following is known. That is, a voltage of an output terminal of a voltage-driven semiconductor switch is detected, and when a voltage equal to or larger than a preset value is detected, a gate resistance value of a discharge path for discharging gate charges is changed to a larger value.

The gate resistance value can be changed to a larger value by providing two discharge paths and blocking one of those paths (see, for example, Patent Literature 1). When the gate resistance value of the discharge path is changed to a larger value, a speed at which a gate voltage decreases can be reduced, and thus a current change (di/dt) can be slowed to reduce the surge voltage.

Citation List

Patent Literature

[PTL 1] JP 2001-45740 A
From WO 2016/205929 A1 a gate drive circuit in accordance with the preamble of claim 1 is known.

From US 2018/159522 A1 it is known to connect a capacitance Cs across the main switch. If the main switch is on, the voltage across the capacitance is zero. If the main switch turns off, the capacitance Cs is used to provide a current ICs as a bridge across the main switch in the off state to prevent a rapid decay in the parasitic inductance.

From US 4 947 063 A a clamp 83 illustrated in Figure 9 of this document is known that is designed to change the current through the package inductance, thereby supressing the magnitude of the voltage spike across the package inductance. The clamp is composed of a current source, having a P-channel transistor and an N-channel transistor, as well as further P-channel transistors, a resistor and a capacitor, which cooperate to generate a precision gate voltage for one of the P-channel transistors.

Summary of Invention

Technical Problem

However, the above-mentioned related art has the following problem.

In the related art of Patent Literature 1, a value obtained by adding a fixed value of the surge voltage to the power supply voltage is detected to suppress a peak voltage. Therefore, in the related art of Patent Literature 1, the suppression amount of the surge voltage varies depending on the power supply voltage, and restriction is only allowed with respect to the absolute value of the voltage to be applied to the semiconductor switch, not the actual magnitude of the surge voltage. Now, as an example, consideration is given to a case in which a semiconductor switch is driven through use of a general-purpose gate driver IC having a half bridge as a basic configuration. In this case, with respect to the gate driver IC, the level at which its midpoint potential becomes a negative potential due to the surge voltage caused by the switching cannot be uniquely controlled.

The gate driver IC has a withstand voltage with respect to a negative voltage to be generated by the surge voltage. In order to prevent failure of the gate driver IC due to excess of the withstand voltage, the negative voltage to be generated is required to be suppressed within the range of the withstand voltage. However, the negative voltage of the midpoint potential cannot be controlled by the level of the power supply voltage just by suppressing the peak voltage of the voltage including the surge voltage which is to be applied to the semiconductor switch, and thus prevention of the excess of the withstand voltage is difficult.

The present invention has been made to solve the above-mentioned problem, and has an object to provide a gate drive circuit and a power conversion device with which a surge voltage can be suppressed while increase in switching loss to be caused when a semiconductor switch performs switching is suppressed.

Solution to Problem

This object of the present invention is achieved as defined in claim 1 and in claim 4. Embodiments of the present invention are given in the dependent claims.

Further, according to the present invention, there is provided a power conversion device including the gate drive circuit of the present invention.

Advantageous Effect of Invention

According to the present invention, the gate drive circuit and the power conversion device with which the surge voltage can be suppressed while increase in switching loss to be caused when the semiconductor switch performs switching is suppressed, can be provided.

Brief Description of Drawings

FIG. 1 is a block diagram for illustrating a gate drive circuit according to a first embodiment of the present invention and a peripheral configuration thereof.

FIG. 2 is a circuit diagram for illustrating details of a gate discharge current adjustment circuit illustrated in FIG. 1 in the first embodiment of the present invention.

FIG. 3 is a chart for illustrating waveforms of respective parts related to a power MOSFET and an inductor in the first embodiment of the present invention.

FIG. 4 is a diagram for illustrating a schematic configuration of a power conversion device including the gate drive circuit according to the first embodiment of the present invention.

FIG. 5 is a circuit diagram for illustrating details of a gate discharge current adjustment circuit included in a gate drive circuit according to an example not forming part of the present invention.

FIG. 6 is a circuit diagram for illustrating details of a gate discharge current adjustment circuit included in a gate drive circuit according to a further example not forming part of the present invention.

Description of Embodiments

A gate drive circuit and a power conversion device according to exemplary embodiments of the present invention are described below with reference to the drawings. In the following description, the same components are denoted by the same reference symbols.

First Embodiment

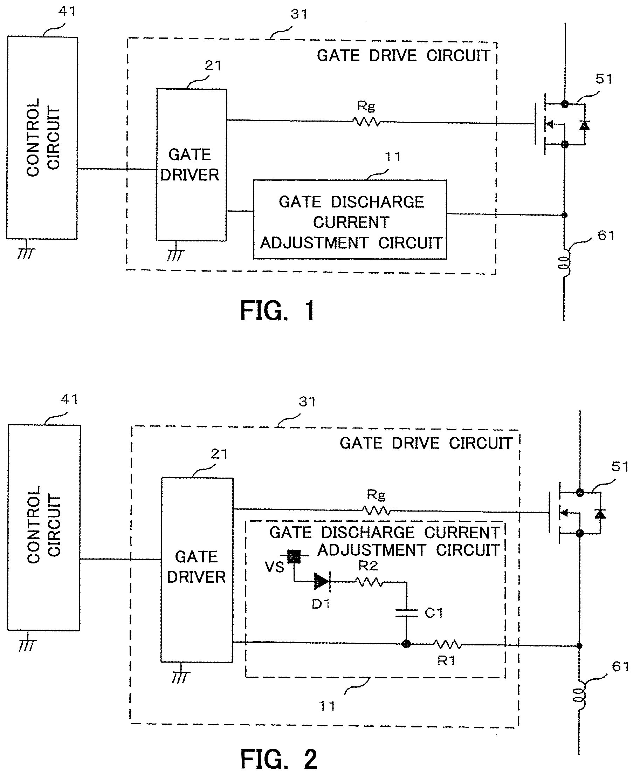

FIG. 1 is a block diagram for illustrating a gate drive circuit according to a first embodiment of the present invention and a peripheral configuration thereof. Specifically, one semiconductor switch forming a power conversion device of a single-phase or multi-phase bridge type, and a peripheral part thereof are extracted.

A semiconductor switch 51 is an N-channel power MOSFET. In the following description, the semiconductor switch 51 is referred to as "power MOSFET 51." The ON/OFF drive of the power MOSFET 51 is performed by a gate drive circuit 31 connected between a control circuit 41 and the power MOSFET 51. An inductor 61 connected to a source terminal of the power MOSFET 51 indicates an inductance component of a wiring line connected to the source terminal.

Next, an internal configuration of the gate drive circuit 31 is described. A gate driver 21 receives from the control circuit 41 an ON/OFF control signal which uses a GND potential as a reference. Then, the gate driver 21 amplifies a drive force to convert the received ON/OFF control signal into drive output which uses a potential of the source terminal of the power MOSFET 51 as a reference. Further, the gate driver 21 supplies a voltage between a gate terminal and the source terminal of the power MOSFET 51 via a gate resistor Rg, to thereby perform the ON/OFF drive of the power MOSFET 51. The gate resistor Rg has a function of adjusting a switching speed or the like.

In the first embodiment, the source terminal corresponds to a first terminal, a drain terminal corresponds to a second terminal, and the gate driver 21 corresponds to a gate drive unit.

Further, a gate discharge current adjustment circuit 11 is connected between the source terminal of the power MOSFET 51 and the gate driver 21. The gate discharge current adjustment circuit 11 is a configuration serving as a core of the first embodiment, and is described in further detail.

FIG. 2 is a circuit diagram for illustrating details of the gate discharge current adjustment circuit 11 illustrated in FIG. 1 in the first embodiment of the present invention. The gate discharge current adjustment circuit 11 includes a series circuit and a voltage source VS. The series circuit includes a diode D1, a resistor R2, a capacitor C1, and a resistor R1 which are connected in series. Further, the series circuit is connected between the voltage source VS and the source terminal of the power MOSFET 51. That is, in the series circuit, an end portion on the diode D1 side is connected to the voltage source VS, and an end portion on the resistor R1 side is connected to the source terminal of the power MOSFET 51.

An anode terminal of the diode D1 is connected to the voltage source VS, and a cathode terminal thereof is connected to the resistor R2. Further, one end of the capacitor C1 is connected to the resistor R2, and the other end of the capacitor C1 is connected to the resistor R1. In the first embodiment, the resistor R1 corresponds to a first resistor, the resistor R2 corresponds to a second resistor, and the diode D1 corresponds to a first diode.

Further, one end of the resistor R1 is connected to the other end of the capacitor C1, and is also connected to the gate driver 21. The other end of the resistor R1 is connected to the source terminal of the power MOSFET 51.

That is, the gate discharge current adjustment circuit 11 has such a configuration that the diode D1, the resistor R2, and the capacitor C1 are connected in series between the voltage source VS and a node between the resistor R1 and the gate driver 21. The connection order to connect the diode D1, the resistor R2, and the capacitor C1 in series may be freely set, and the connection order illustrated in FIG. 2 is merely an example.

In this case, the voltage source VS may be a power supply which has any voltage and uses the GND potential as a reference. When a plurality of semiconductor switches 51 are used to form a half bridge, it is suitable to employ as the voltage source VS a gate drive power supply for a lower arm of the half bridge. Further, in the case of application to the lower arm, the diode D1 can be omitted to directly connect the resistor R2 to the voltage source VS.

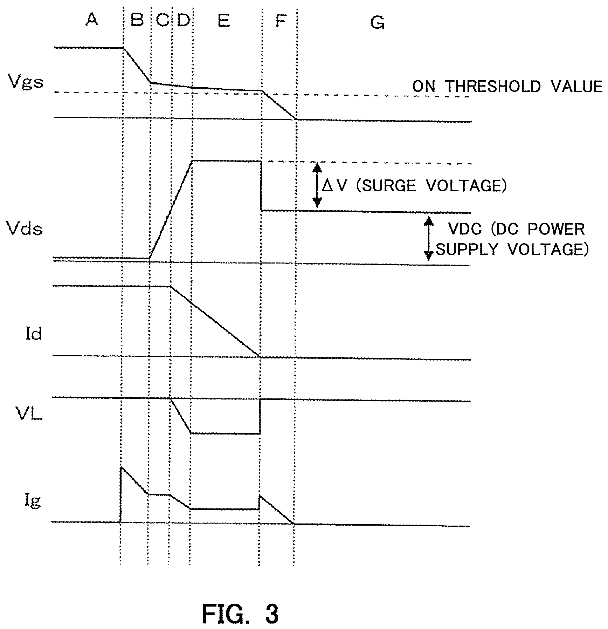

FIG. 3 is a chart for illustrating waveforms of respective parts related to the power MOSFET 51 and the inductor 61 in the first embodiment of the present invention. Specifically, FIG. 3 schematically shows examples of waveforms of respective parts until the power MOSFET 51 driven by the gate drive circuit 31 of FIG. 2 transitions from the ON state to the OFF state.

Reference symbols of FIG. 3 stand for the following matters.

Vgs: gate-source voltage of power MOSFET 51
Vds: drain-source voltage of power MOSFET 51

Id: drain current of power MOSFET 51
VL: voltage across inductor 61
Ig: gate current of power MOSFET 51

The voltage VL across the inductor 61 is positive on the source terminal side of the power MOSFET 51. Further, the gate current Ig is positive in a discharge direction. Further, in the following description, only the reference symbols of Vgs, Vds, Id, VL, and Ig are represented as appropriate.

Next, the operations of the power MOSFET 51 and the inductor 61 in the first embodiment are described in individual sections of from a section A to a section G illustrated in FIG. 3.

<Regarding Section A>

The section A shows a state in which the gate driver 21 performs the ON drive of the power MOSFET 51 based on an ON command output from the control circuit 41. In the section A, a current in a forward direction being a direction from the drain terminal toward the source terminal flows from a DC power supply (not shown) via the inductor 61. At this time, the capacitor C1 is in an equilibrium state in which the capacitor C1 is charged by a voltage obtained by subtracting the voltage drop of the diode D1 from the voltage of the voltage source VS. Therefore, no current flows in the gate discharge current adjustment circuit 11.

<Regarding Section B>

The section B shows a state in which the gate driver 21 starts the OFF drive of the power MOSFET 51 based on a turn-off command output from the control circuit 41. In the section B, Ig flows as a discharge current through a path passing through the gate resistor Rg, the gate driver 21, and the resistor R1 in the stated order. Vgs decreases in accordance with the discharge current. However, switching does not occur until Vgs decreases to a voltage close to an ON threshold value.

<Regarding Section C>

The section C shows a state in which Vgs decreases to a voltage close to the ON threshold value. When Vgs decreases to a voltage close to the ON threshold value, Vds increases along with abrupt increase of an ON resistance of the power MOSFET 51. At this time, a decrease rate of Vgs abruptly decreases due to a Miller effect, and Vgs remains substantially unchanged.

<Regarding Section D>

The section D shows a state in which Vds exceeds a voltage of the DC power supply, and Id starts to decrease. When Vds exceeds the voltage of the DC power supply, Id starts to decrease even when Vgs is a voltage exceeding the ON threshold value. Then, a surge voltage $\Delta V$ is generated in Vds. The surge voltage $\Delta V$ is determined by the product of a decrease speed of Id and a sum of parasitic inductances in a loop in which the current change of Id occurs.

At this time, also in the voltage VL across the inductor 61 being a part of the parasitic inductances in the loop in which the current change occurs, an electromotive voltage is generated in a direction of inhibiting the current change. The electromotive voltage is determined by the product of the decrease speed of Id and an inductance value of the inductor 61. Therefore, the voltage VL across the inductor 61 becomes a negative voltage.

When the power MOSFET 51 is a lower arm of the half bridge, or when the power MOSFET 51 is a low-side switch, a potential of the downstream of the inductor 61 is GND. Meanwhile, when the power MOSFET 51 is an upper arm of the half bridge, or when the power MOSFET 51 is a high-side switch, a potential of the downstream of the inductor 61 becomes a potential obtained by adding the electromotive voltage at the wiring inductance of the lower arm to -Vf being a freewheeling voltage caused by a freewheeling diode or a parasitic diode of the power MOSFET 51 in the lower arm. Therefore, in any case, the source terminal of the power MOSFET 51 has a negative potential.

In this manner, a current flows from the voltage source VS toward the source terminal of the power MOSFET 51 in accordance with a magnitude of the negative potential of the source terminal of the power MOSFET 51. As a result, the reference side of the gate driver 21 has a high potential corresponding to the amount of voltage drop at the resistor R1 with respect to the source terminal of the power MOSFET 51, and a voltage across the gate resistor Rg which determines a discharge speed of gate charges of the power MOSFET 51 decreases. Therefore, the gate current Ig of the power MOSFET 51 decreases.

<Regarding Section E>

The section E shows a state in which Id transitions to zero while Vds maintains the equilibrium state. In the previous section D, the voltage drop at the resistor R1 increases as the absolute value of the negative voltage related to VL increases. As a result, the voltage across the gate resistor Rg further decreases, and the gate current Ig further decreases as well.

As a result, the turn-off speed is reduced, and the surge voltage ΔV is suppressed. That is, the current from the voltage source VS flows through the source terminal of the power MOSFET 51 via the resistor R1 so that the gate current Ig is adjusted to obtain a constant surge voltage ΔV in Vds. Therefore, in the section E, Id transitions to zero while Vds maintains the equilibrium state.

<Regarding Section F>

The section F shows a state in which Id becomes zero and the power MOSFET 51 is completely turned off. In the previous section E, when Id finally becomes zero, the electromotive voltage of VL becomes zero, and the surge voltage ΔV of Vds becomes zero as well. As a result, in the section F, the power MOSFET 51 is completely brought into the OFF state. At this time, the current flowing from the voltage source Vs becomes zero as well, and Ig flows through the path passing through the gate resistor Rg, the gate driver 21, and the resistor R1 in the stated order to finally become zero.

<Regarding Section G>

The section G shows a state in which Ig becomes zero and the power MOSFET 51 is maintained in the OFF state. The gate driver 21 maintains the OFF state of the power MOSFET 51 by a voltage supplied between the gate resistor Rg and the resistor R1 based on the OFF signal from the control circuit 41.

Next, description is given of a relationship between a resistance value of the gate discharge current adjustment circuit 11 of FIG. 2 and a restriction value of the surge voltage. Specifically, description is given in detail of the relationship between the resistance value and the restriction value of the surge voltage by means of an example of a case in which the gate drive circuit 31 of FIG. 2 is applied to a power conversion device having a half bridge as a basic configuration.

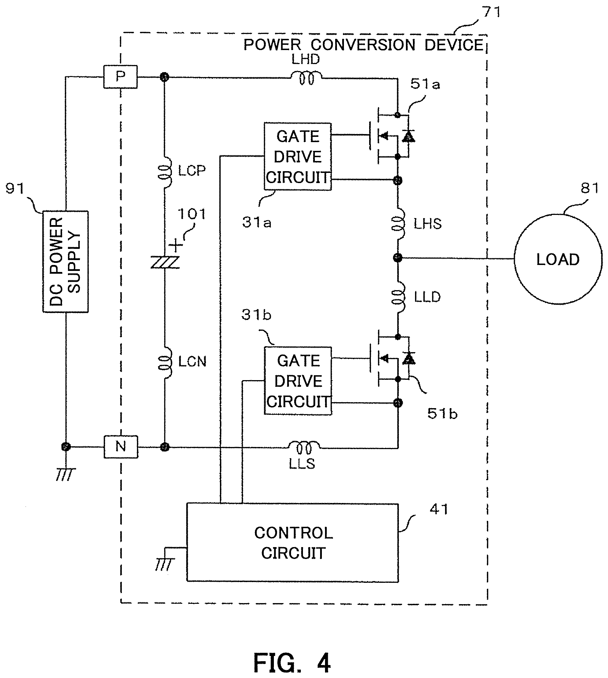

FIG. 4 is a diagram for illustrating a schematic configuration of the power conversion device including the gate drive circuit according to the first embodiment of the present invention. FIG. 4 shows an overall configuration of a system configured to convert DC power of a DC power supply 91 by a power conversion device 71 to drive a load 81, for example, a motor.

The power conversion device 71 includes a half bridge and a smoothing capacitor 101. The half bridge includes N-channel power MOSFETs 51a and 51b which are connected in series. The smoothing capacitor 101 is connected in parallel to the half bridge. The smoothing capacitor 101 is a capacitor for smoothing a volage between DC terminals at the time of switching of the power MOSFETs 51a and 51b.

A positive terminal of the DC power supply 91 is connected to a high voltage-side DC terminal P of the power conversion device 71, and a negative terminal of the DC power supply 91 is connected to a low voltage-side DC terminal N of the power conversion device 71. Further, the load 81, for example, a motor winding is connected to a midpoint of the half bridge. In FIG. 4, for simplifying the description, the power conversion device 71 includes only one half bridge serving as a basic unit. However, the power conversion device 71 may have a configuration in which a plurality of half bridges are connected in parallel, depending on a type of the motor or the like serving as the load 81.

A gate drive circuit 31a according to the first embodiment is connected to the power MOSFET 51a, and a gate drive circuit 31b according to the first embodiment is connected to the power MOSFET 51b. Further, the control circuit 41 is connected on the upstream of the gate drive circuits 31a and 31b. In this case, the gate drive circuits 31a and 31b have internal circuit configurations similar to that of the gate drive circuit 31 of FIG. 2.

Inductors LHD, LHS, LLD, LLS, LCP, and LCN illustrated in the power conversion device 71 all indicate parasitic inductance components of respective internal wiring portions. In this case, inductance values of the respective inductors are represented by the above-mentioned reference symbols, and an inductance value as a sum of those values is defined as Lall.

Further, similarly, resistance values of the resistors R1 and R2 in the gate drive circuits 31a and 31b are represented by the above-mentioned reference symbols R1 and R2. A voltage across a component is represented with "V" being prefixed to a reference symbol. In this manner, for example, the voltage across the inductor LHD is represented by VLHD.

Now, description is given of an operation of a case in which the gate drive circuit 31b turns off the power MOSFET 51b from a state in which the power MOSFET 51a is turned off, the power MOSFET 51b is turned on, and a current flows through a path passing through the DC power supply 91, the load 81, and the power MOSFET 51b in the stated order.

A series of operations in the power MOSFET 51b and the gate drive circuit 31b at this time is similar to the above-mentioned operations of FIG. 3. Thus, numerical values in the state of the section E are particularly described in detail.

A gate-source voltage in a Miller region while the power MOSFET 51b is turned off, that is, the gate-source voltage in the section E is defined as Vgs_m. At this time, VLLS is expressed by the following expression (1).

$$VLLS < \frac{R1 + R2}{R1} \cdot Vgs\_m \quad (1)$$

Further, VLLS and VLall have a relationship of the following expression (2).

$$VLall = \frac{Lall}{LLS} \cdot VLLS \quad (2)$$

That is, the following expression (3) can be obtained by the expressions (1) and (2) given above.

$$VLall < \frac{Lall}{LLS} \cdot \frac{R1 + R2}{R1} \cdot Vgs\_m \quad (3)$$

In this manner, it is understood that, when the resistance values of the resistor R1 and the resistor R2 are set based on the expression (3) given above, the maximum surge voltage VLall to be applied between the drain terminal and the source terminal of the power MOSFET 51b can be freely controlled.

Next, description is given of an operation of a case in which the gate drive circuit 31a turns off the power MOSFET 51a from a state in which the power MOSFET 51b is turned off, the power MOSFET 51a is turned on, and a current flows through a path passing through the DC power supply 91, the power MOSFET 51a, and the load 81 in the stated order.

A series of operations in the power MOSFET 51a and the gate drive circuit 31a at this time is similar to the above-mentioned operations of FIG. 3. Thus, numerical values in the state of the section E are particularly described in detail.

A gate-source voltage of a Miller region while the power MOSFET 51a is turned off, that is, the gate-source voltage in the section E is defined as Vgs_m similarly to the power MOSFET 51b. At this time, VLLS+VLLD+VLHS is expressed by the following expression (4).

$$VLLS + VLLD + VLHS < \frac{R1 + R2}{R1} \cdot Vgs\_m \quad (4)$$

Further, VLLS+VLLD+VLHS and VLall have a relationship of the following expression (5).

$$VLall = \frac{Lall}{LLS + LLD + LHS} \cdot (VLLS + VLLD + VLHS) \quad (5)$$

Then, the following expression (6) can be obtained by the expressions (4) and (5) given above.

$$VLall < \frac{Lall}{LLS + LLD + LHS} \cdot \frac{R1 + R2}{R1} \cdot Vgs\_m \quad (6)$$

In this manner, it is understood that, when the resistance values of the resistor R1 and the resistor R2 are set based on the expression (6) given above, the maximum surge voltage VLall to be applied between the drain terminal and the source terminal of the power MOSFET 51b can be freely controlled.

Lall, LLS, LLD, and LHS are constants which are uniquely determined by wiring structures such as a bus bar and a printed board connected to the power conversion device 71, and have almost no variations among individuals. Vgs_m has a slight individual variation, but the variation falls within less than 2 V even when the maximum variation is assumed including temperature characteristics. In view of the above, when a ratio between the resistance values of the resistor R1 and the resistor R2 is set to, for example, 1:1, the individual variation of VLall can be suppressed to less than 4 V at most.

As described above, according to the first embodiment, only the section E of FIG. 3 in which the surge voltage is generated has a configuration for reducing the turn-off speed. With such a configuration, the surge voltage can be reduced more appropriately while the increase in turn-off loss at the time of switching is suppressed. As a result, a semiconductor switch having a low withstand voltage, that is, a small conduction loss can be applied, and hence the loss at the semiconductor switch can be reduced.

Therefore, through reduction of the size of the semiconductor switch, simplification of a configuration of a heat radiating system, or application of both of those methods, both of downsizing of a product and reduction in cost can be achieved at the same time.

Further, the generated surge voltage is automatically fed back to the gate drive circuit so that the surge voltage is restricted. Therefore, a surge restriction voltage is independent of the characteristic variations of the semiconductor switch. As a result, individual adjustment with respect to the characteristic variations of the semiconductor switch is not required during design or manufacture, and thus margin design considering the characteristic variations of the semiconductor switch can be eliminated. Therefore, a gate drive circuit having high reliability and a power conversion device including the gate drive circuit can be manufactured at lower cost.

Moreover, with the above-mentioned configuration capable of suppressing the surge voltage $\Delta V$, the negative voltage to be generated by the surge voltage $\Delta V$ can be suppressed as well. As a result, the above-mentioned configuration capable of suppressing the surge voltage $\Delta V$ also contributes to protection against the negative voltage to be applied to the gate driver IC. Therefore, a general-purpose gate driver IC can be used as the gate driver 21.

Further, the configuration for suppressing the surge voltage can be achieved only by a small number of passive elements configured to allow a current to flow by an induced voltage generated by a parasitic inductance that always exists in the wiring of the power conversion device. Therefore, the configuration for suppressing the surge voltage is very robust and requires low cost.

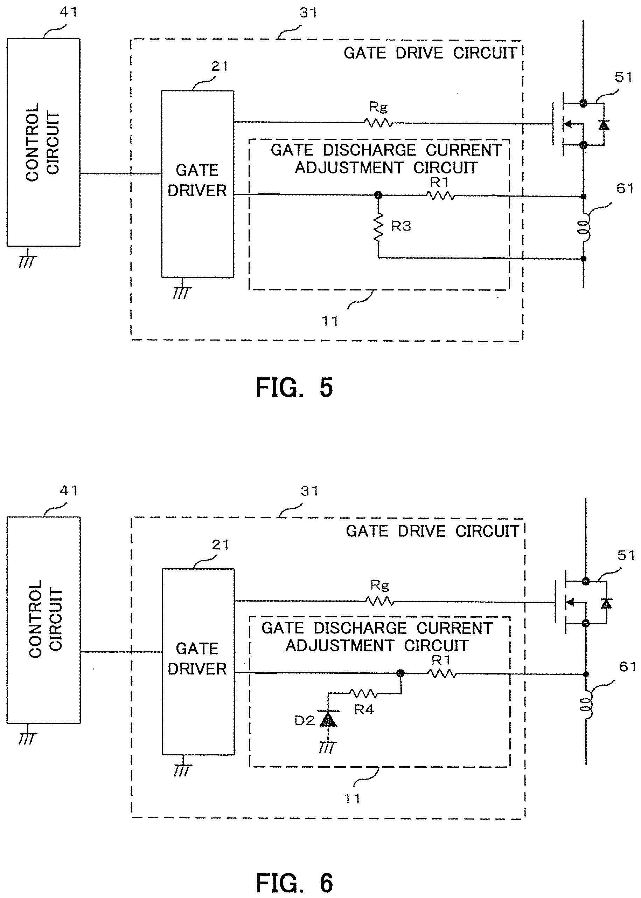

FIG. 5 is a circuit diagram for illustrating details of a gate discharge current adjustment circuit included in a gate drive circuit according to an example not forming part of the present invention. As compared to FIG. 2 in the first embodiment described above, the configuration of FIG. 5 differs only in the internal configuration of the gate discharge current adjustment circuit 11.

The gate discharge current adjustment circuit 11 illustrated in FIG. 5 includes the resistor R1 and a resistor R3. One end of the resistor R1 is connected to the gate driver 21, and the other end thereof is connected to the source terminal of the power MOSFET 51. Further, one end of the resistor R3 is connected to the gate driver 21, and the other end thereof is connected to the downstream side of the inductor 61. That is, the resistor R3 is connected between the downstream side of the inductor 61 and the node between the resistor R1 and the gate driver 21. In the example, the resistor R1 corresponds to the first resistor, and the resistor R3 corresponds to a third resistor.

Next, the operations of the power MOSFET 51 and the inductor 61 in the example are described in individual sections of from the section A to the section G illustrated in FIG. 3.

<Regarding Section A>

The section A shows a state in which the gate driver 21 performs the ON drive of the power MOSFET 51 based on an ON command output from the control circuit 41. In the section A, a current in a forward direction being a direction directed from the drain terminal toward the source terminal flows from a DC power supply (not shown) via the inductor 61. At this time, both ends of the inductor 61 have the same potential, and no current flows in the gate discharge current adjustment circuit 11.

<Regarding Section B>

The section B shows a state in which the gate driver 21 starts the OFF drive of the power MOSFET 51 based on a turn-off command output from the control circuit 41. In the section B, Ig flows as a discharge current through a path of a parallel circuit including the resistor R3 and a path passing through the gate resistor Rg, the gate driver 21, and the resistor R1 in the stated order. Vgs decreases in accordance with the discharge current. However, switching does not occur until Vgs decreases to a voltage close to an ON threshold value.

<Regarding Section C>

The section C shows a state in which Vgs decreases to a voltage close to the ON threshold value. When Vgs decreases to a voltage close to the ON threshold value, Vds increases along with abrupt increase of an ON resistance of the power MOSFET 51. At this time, a decrease rate of Vgs abruptly decreases due to a Miller effect, and Vgs remains substantially unchanged.

<Regarding Section D>

The section D shows a state in which Vds exceeds a voltage of the DC power supply, and Id starts to decrease.

When Vds exceeds the voltage of the DC power supply, Id starts to decrease even when Vgs is a voltage exceeding the ON threshold value. Then, the surge voltage $\Delta$V is generated in Vds. The surge voltage $\Delta$V is determined by the product of a decrease speed of Id and a sum of parasitic inductances in a loop in which the current change of Id occurs.

At this time, also in the voltage VL across the inductor 61 being a part of the parasitic inductances in the loop in which the current change occurs, an electromotive voltage is generated in a direction of inhibiting the current change. The electromotive voltage is determined by the product of the decrease speed of Id and an inductance value of the inductor 61. Therefore, the voltage VL across the inductor 61 becomes a negative voltage.

In this manner, a current flows from the downstream side of the inductor 61 toward the source terminal of the power MOSFET 51 via the resistor R3 and the resistor R1, in accordance with the magnitude of the electromotive voltage generated across the inductor 61. The downstream side of the inductor 61 has a potential to be used as a reference in the example.

As a result, the reference side of the gate driver 21 has a high potential corresponding to the amount of voltage drop at the resistor R1 with respect to the source terminal of the power MOSFET 51, and a voltage across the gate resistor Rg which determines a discharge speed of gate charges of the power MOSFET 51 decreases. Therefore, the gate current Ig of the power MOSFET 51 decreases.

<Regarding Section E>

The section E shows a state in which Id transitions to zero while Vds maintains the equilibrium state. In the previous section D, the voltage drop at the resistor R1 increases as the absolute value of the negative voltage related to VL increases. Meanwhile, the current flowing through the resistor R3 increases. As a result, the voltage across the gate resistor Rg further decreases, and the gate current Ig further decreases as well.

As a result, the turn-off speed is reduced, and the surge voltage $\Delta$V is suppressed. That is, the current flows through the source terminal of the power MOSFET 51 via the resistor R3 and the resistor R1 so that the gate current Ig is adjusted to obtain a constant surge voltage $\Delta$V in Vds. Therefore, in the section E, Id transitions to zero while Vds maintains the equilibrium state.

<Regarding Section F>

The section F shows a state in which Id becomes zero and the power MOSFET 51 is completely turned off. In the previous section E, when Id finally becomes zero, the electromotive voltage of VL becomes zero, and the surge voltage $\Delta$V of Vds becomes zero as well. As a result, in the section F, the power MOSFET 51 is completely brought into the OFF state. At this time, the current flowing from the downstream of the inductor 61 via the resistor R3 and the resistor R1 becomes zero as well, and Ig flows through the path of the parallel circuit including the resistor R3 and the path passing through the gate resistor Rg, the gate driver 21, and the resistor R1 in the stated order to finally become zero.

<Regarding Section G>

The section G shows a state in which Ig becomes zero and the power MOSFET 51 is maintained in the OFF state. The gate driver 21 maintains the OFF state of the power MOSFET 51 by a voltage supplied between the gate resistor Rg and the resistor R1 based on the OFF signal from the control circuit 41.

Next, description is given of a relationship between each resistance value of the gate discharge current adjustment circuit 11 of FIG. 5 and a restriction value of the surge voltage. Specifically, description is given in detail of the relationship by means of an example of a case in which the gate drive circuit 31 of FIG. 5 is applied to the power conversion device 71 illustrated in FIG. 4 which has a half bridge as a basic configuration.

Description of FIG. 4 is given above, and hence is omitted here. The power conversion device 71 illustrated in FIG. 4 can employ the gate drive circuit 31 according to the example illustrated in FIG. 5. Therefore, the power conversion device 71 illustrated in FIG. 4 also corresponds to a power conversion device according to the example.

Now, description is given of an operation of a case in which the gate drive circuit 31b turns off the power MOSFET 51b from a state in which the power MOSFET 51a is turned off, the power MOSFET 51b is turned on, and a current flows through a path passing through the DC power supply 91, the load 81, and the power MOSFET 51b in the stated order.

A series of operations in the power MOSFET 51b and the gate drive circuit 31b at this time is similar to the above-mentioned operations of FIG. 3. Thus, numerical values in the state of the section E are particularly described in detail.

A gate-source voltage in a Miller region while the power MOSFET 51b is turned off, that is, the gate-source voltage in the section E is defined as Vgs_m. At this time, VLLS is expressed by the following expression (7).

$$VLLS < \frac{R1 + R3}{R1} \cdot Vgs\_m \quad (7)$$

Further, VLLS and VLall have a relationship of the following expression (8).

$$VLall = \frac{Lall}{LLS} \cdot VLLS \quad (8)$$

That is, the following expression (9) can be obtained by the expressions (7) and (8) given above.

$$VLall < \frac{Lall}{LLS} \cdot \frac{R1 + R3}{R1} \cdot Vgs\_m \quad (9)$$

In this manner, it is understood that, when the resistance values of the resistor R1 and the resistor R3 are set based on the expression (9) given above, the maximum surge voltage VLall to be applied between the drain terminal and the source terminal of the power MOSFET 51b can be freely controlled.

Next, description is given of an operation of a case in which the gate drive circuit 31a turns off the power MOSFET 51a from a state in which the power MOSFET 51b is turned off, the power MOSFET 51a is turned on, and a current flows through a path passing through the DC power supply 91, the power MOSFET 51a, and the load 81 in the stated order.

A series of operations in the power MOSFET 51a and the gate drive circuit 31a at this time is similar to the above-mentioned operations of FIG. 3. Thus, numerical values in the state of the section E are particularly described in detail.

A gate-source voltage of a Miller region while the power MOSFET 51a is turned off, that is, the gate-source voltage in the section E is defined as Vgs_m similarly to the power MOSFET 51b. At this time, VLHS is expressed by the following expression (10).

$$VLHS < \frac{R1 + R3}{R1} \cdot Vgs\_m \quad (10)$$

Further, VLHS and VLall have a relationship of the following expression (11).

$$VLall = \frac{Lall}{LHS} \cdot VLHS \quad (11)$$

That is, the following expression (12) can be obtained by the expressions (10) and (11) given above.

$$VLall < \frac{Lall}{LHS} \cdot \frac{R1 + R3}{R1} \cdot Vgs\_m \quad (12)$$

In this manner, it is understood that, when the resistance values of the resistor R1 and the resistor R3 are set based on the expression (12) given above, the maximum surge voltage VLall to be applied between the drain terminal and the source terminal of the power MOSFET 51b can be freely controlled.

Lall, LLS, and LHS are constants which are uniquely determined by wiring structures such as a bus bar and a printed board connected to the power conversion device 71 and have almost no variations among individuals. Vgs_m has a slight individual variation, but the variation falls within less than 2 V even when the maximum variation is assumed including temperature characteristics. In view of the above, when a ratio between the resistance values of the resistor R1 and the resistor R3 is set to, for example, 1:1, the individual variation of VLall can be suppressed to less than 4 V at most.

As described above, according to the example, effects similar to those in the above-mentioned first embodiment can be obtained, and the circuit configuration and the used components of the example are simpler and lower in cost as compared to those in the above-mentioned first embodiment. Therefore, the example is effective in terms of further suppressing manufacturing cost of the gate drive circuit and the power conversion device.

Further example not forming part of the present invention

FIG. 6 is a circuit diagram for illustrating details of a gate discharge current adjustment circuit included in a gate drive circuit according to a further example not forming part of the present invention. As compared to FIG. 2 in the first embodiment described above, the configuration of FIG. 6 differs only in the internal configuration of the gate discharge current adjustment circuit 11.

The gate discharge current adjustment circuit 11 illustrated in FIG. 6 includes the resistor R1, a resistor R4, and a diode D2. An anode terminal of the diode D2 is connected to GND, and a cathode terminal thereof is connected to one end of the resistor R4. The other end of the resistor R4 is connected to the node between the gate driver 21 and the resistor R1. The connection order to connect the diode D2 and the resistor R4 in series may be freely set, and the connection order illustrated in FIG. 6 is merely an example.

Further, the resistor R1 is connected between the gate driver 21 and the source terminal of the power MOSFET 51. In the further example, the resistor R1 corresponds to the first resistor, the resistor R4 corresponds to a fourth resistor, and the diode D2 corresponds to a second diode.

Next, the operations of the power MOSFET 51 and the inductor 61 in the further example are described in individual sections of from the section A to the section G illustrated in FIG. 3.

<Regarding Section A>

The section A shows a state in which the gate driver 21 performs the ON drive of the power MOSFET 51 based on an ON command output from the control circuit 41. In the section A, a current in a forward direction being a direction directed from the drain terminal toward the source terminal flows from a DC power supply (not shown) via the inductor 61. At this time, both ends of the inductor 61 have the same potential, and no current flows in the gate discharge current adjustment circuit 11.

<Regarding Section B>

The section B shows a state in which the gate driver 21 starts the OFF drive of the power MOSFET 51 based on a turn-off command output from the control circuit 41. In the section B, Ig flows as a discharge current through a path passing through the gate resistor Rg, the gate driver 21, and the resistor R1 in the stated order. Vgs decreases in accordance with the discharge current. However, switching does not occur until Vgs decreases to a voltage close to an ON threshold value.

<Regarding Section C>

The section C shows a state in which Vgs decreases to a voltage close to the ON threshold value. When Vgs decreases to a voltage close to the ON threshold value, Vds increases along with abrupt increase of an ON resistance of the power MOSFET 51. At this time, a decrease rate of Vgs abruptly decreases due to a Miller effect, and Vgs remains substantially unchanged.

<Regarding Section D>

The section D shows a state in which Vds exceeds a voltage of the DC power supply, and Id starts to decrease. When Vds exceeds the voltage of the DC power supply, Id starts to decrease even when Vgs is a voltage exceeding the ON threshold value. Then, the surge voltage $\Delta V$ is generated in Vds. The surge voltage $\Delta V$ is determined by the product of a decrease speed of Id and a sum of parasitic inductances in a loop in which the current change of Id occurs.

At this time, also in the voltage VL across the inductor 61 being a part of the parasitic inductances in the loop in which the current change occurs, an electromotive voltage is generated in a direction of inhibiting the current change. The electromotive voltage is determined by the product of the decrease speed of Id and an inductance value of the inductor 61. Therefore, the voltage VL across the inductor 61 becomes a negative voltage.

When the power MOSFET 51 is a lower arm of the half bridge, or when the power MOSFET 51 is a low-side switch, a potential of the downstream of the inductor 61 is GND. Meanwhile, when the power MOSFET 51 is an upper arm of the half bridge, or when the power MOSFET 51 is a high-side switch, a potential of the downstream of the inductor 61 becomes a potential obtained by adding the electromotive voltage at the wiring inductance of the lower arm to -Vf being a freewheeling voltage caused by a freewheeling diode or a parasitic diode of the power MOSFET 51 in the lower arm. Therefore, in any case, the source terminal of the power MOSFET 51 has a negative potential.

In this manner, a current flows from GND toward the source terminal of the power MOSFET 51 through a path passing through the diode D2, the resistor R4, and the resistor R1 in the stated order, in accordance with the magnitude of the negative potential of the source terminal of the power MOSFET 51.

As a result, the reference side of the gate driver 21 has a high potential corresponding to the amount of voltage drop at the resistor R1 with respect to the source terminal of the power MOSFET 51, and a voltage across the gate resistor Rg which determines a discharge speed of gate charges of the power MOSFET 51 decreases. Therefore, the gate current Ig of the power MOSFET 51 decreases.

<Regarding Section E>

The section E shows a state in which Id transitions to zero while Vds maintains the equilibrium state. In the previous section D, the voltage drop at the resistor R1 increases as the absolute value of the negative voltage related to VL increases. Meanwhile, the current flowing from GND via the resistor R4 and the resistor R1 increases as well. Therefore, the voltage across the gate resistor Rg further decreases, and the gate current Ig further decreases as well.
As a result, the turn-off speed is reduced, and the surge voltage $\Delta V$ is suppressed. That is, the current flows through the resistor R1 from GND so that the gate current Ig is adjusted to obtain a constant surge voltage $\Delta V$ in Vds. Therefore, in the section E, Id transitions to zero while Vds maintains the equilibrium state.

<Regarding Section F>

The section F shows a state in which Id becomes zero and the power MOSFET 51 is completely turned off. In the previous section E, when Id finally becomes zero, the electromotive voltage of VL becomes zero, and the surge voltage $\Delta V$ of Vds becomes zero as well. As a result, in the section F, the power MOSFET 51 is completely brought into the OFF state. At this time, the current flowing from GND via the resistor R4 and the resistor R1 becomes zero as well, and Ig flows through the path passing through the gate resistor Rg, the gate driver 21, and the resistor R1 in the stated order to finally become zero.

<Regarding Section G>

The section G shows a state in which Ig becomes zero and the power MOSFET 51 is maintained in the OFF state. The gate driver 21 maintains the OFF state of the power MOSFET 51 by a voltage supplied between the gate resistor Rg and the resistor R1 based on the OFF signal from the control circuit 41.
Next, description is given of a relationship between each resistance value of the gate discharge current adjustment circuit 11 of FIG. 6 and a restriction value of the surge voltage. Specifically, description is given in detail of the relationship by means of an example of a case in which the gate drive circuit 31 of FIG. 6 is applied to the power conversion device 71 illustrated in FIG. 4 which has a half bridge as a basic configuration.
Description of FIG. 4 is given above, and hence is omitted here. The power conversion device 71 illustrated in FIG. 4 can employ the gate drive circuit 31 according to the further example illustrated in FIG. 6. Therefore, the power conversion device 71 illustrated in FIG. 4 also corresponds to a power conversion device according to the further example.
Now, description is given of an operation of a case in which the gate drive circuit 31b turns off the power MOSFET 51b from a state in which the power MOSFET 51a is turned off, the power MOSFET 51b is turned on, and a current flows through a path passing through the DC power supply 91, the load 81, and the power MOSFET 51b in the stated order.
A series of operations in the power MOSFET 51b and the gate drive circuit 31b at this time is similar to the above-mentioned operations of FIG. 3. Thus, numerical values in the state of the section E are particularly described in detail.
A gate-source voltage in a Miller region while the power MOSFET 51b is turned off, that is, the gate-source voltage in the section E is defined as Vgs _m. At this time, VLLS is expressed by the following expression (13).

$$VLLS < \frac{R1 + R4}{R1} \cdot Vgs\_m \quad (13)$$

Further, VLLS and VLall have a relationship of the following expression (14).

$$VLall = \frac{Lall}{LLS} \cdot VLLS \quad (14)$$

That is, the following expression (15) can be obtained by the expressions (13) and (14) given above.

$$VLall < \frac{Lall}{LLS} \cdot \frac{R1 + R4}{R1} \cdot Vgs\_m \quad (15)$$

In this manner, it is understood that, when the resistance values of the resistor R1 and the resistor R4 are set based on the expression (15) given above, the maximum surge voltage VLall to be applied between the drain terminal and the source terminal of the power MOSFET 51b can be freely controlled.

Next, description is given of an operation of a case in which the gate drive circuit 31a turns off the power MOSFET 51a from a state in which the power MOSFET 51b is turned off, the power MOSFET 51a is turned on, and a current flows through a path passing through the DC power supply 91, the power MOSFET 51a, and the load 81 in the stated order.

A series of operations in the power MOSFET 51a and the gate drive circuit 31a at this time is similar to the above-mentioned operations of FIG. 3. Thus, numerical values in the state of the section E are particularly described in detail.

A gate-source voltage of a Miller region while the power MOSFET 51a is turned off, that is, the gate-source voltage in the section E is defined as Vgs_m similarly to the power MOSFET 51b. At this time, VLLS+VLLD+VLHS is expressed by the following expression (16).

$$\text{VLLS} + \text{VLLD} + \text{VLHS} < \frac{\text{R1} + \text{R4}}{\text{R1}} \cdot \text{Vgs\_m} \quad (16)$$

Further, VLLS+VLLD+VLHS and VLall have a relationship of the following expression (17).

$$\text{VLall} = \frac{\text{Lall}}{\text{LLS} + \text{LLD} + \text{LHS}} \cdot (\text{VLLS} + \text{VLLD} + \text{VLHS}) \quad (17)$$

That is, the following expression (18) can be obtained by the expressions (16) and (17) given above.

$$\text{VLall} < \frac{\text{Lall}}{\text{LLS} + \text{LLD} + \text{LHS}} \cdot \frac{\text{R1} + \text{R4}}{\text{R1}} \cdot \text{Vgs\_m} \quad (18)$$

In this manner, it is understood that, when the resistance values of the resistor R1 and the resistor R4 are set based on the expression (18) given above, the maximum surge voltage VLall to be applied between the drain terminal and the source terminal of the power MOSFET 51b can be freely controlled.

Lall, LLS, LLD, and LHS are constants which are uniquely determined by wiring structures such as a bus bar and a printed board connected to the power conversion device 71, and have almost no variations among individuals. Vgs_m has a slight individual variation, but the variation falls within less than 2 V even when the maximum variation is assumed including temperature characteristics. In view of the above, when a ratio between the resistance values of the resistor R1 and the resistor R4 is set to, for example, 1:1, the individual variation of VLall can be suppressed to less than 4 V at most.

As described above, according to the further example, effects similar to those in the above-mentioned first embodiment can be obtained, and the circuit configuration and the used components of the further example are simpler and lower in cost as compared to those in the above-mentioned first embodiment. Therefore, as in the example, the further example is effective in terms of further suppressing manufacturing cost of the gate drive circuit and the power conversion device.

The present invention is not limited to the above-mentioned first embodiment.

In the first embodiment, the present invention is applied to the power conversion device of the half bridge type. However, the power conversion device to which the present invention is applicable is not limited to the power conversion device of the half bridge type. The power conversion device is only required to perform switching of the semiconductor switch at high speed.

Therefore, the power conversion device may be, for example, a power conversion device of an H-bridge type (two-phase bridge), a power conversion device of a three-phase bridge type, or a power conversion device of a bridge type of four or more phases. When the power conversion device allows a large current to flow, a plurality of semiconductor switches may be connected in parallel. The gate drive circuit according to the present invention can be used to switch one or more semiconductor switches included in the power conversion device.

Further, in the first embodiment, the power MOSFET is used and described as the semiconductor switch to be used in the power conversion device. However, the semiconductor switch may be IGBT or other voltage-driven semiconductor switches.

Further, the gate drive circuit may have a configuration in which, in order to individually control each of the turn-on switching speed and the turn-off switching speed, a circuit is connected in parallel to the gate resistor Rg so that the turn-on gate current and the turn-off gate current flow through different paths. Thus, similarly to the power conversion device, the gate drive circuit is not limited to the configurations as the first embodiment as well.

Further, application of the first embodiment to the upper arm and the lower arm of the half bridge can be performed in any combination.

Reference Signs List

11 gate discharge current adjustment circuit, 21 gate driver (gate drive unit), 31, 31a, 31b gate drive circuit, 41 control circuit, 51, 51a, 51b power MOSFET, 61 inductor (parasitic inductance of wiring), 71 power conversion device, 81 load, 91 DC power supply, LHD, LHS, LLD, LLS, LCP, LCN inductor (parasitic inductance), R1 resistor (first resistor), R2 resistor (second resistor), R3 resistor (third resistor), R4 resistor (fourth resistor), Rg gate resistor, D1 diode (first diode), D2 diode (second diode), VS voltage source

## Claims

1. A gate drive circuit (31), comprising:

    a gate drive unit (21) configured to perform ON/OFF control of a semiconductor switch including a first terminal, a second terminal, and a gate terminal;
    a gate resistor (Rg) connected between the gate drive unit (21) and the gate terminal; and
    a gate discharge current adjustment circuit (11) which is connected between the gate drive unit (21) and the first terminal, and is configured to change, when the gate drive unit (21) turns off the semiconductor switch, a discharge speed at which gate charges of the semiconductor switch are discharged via the gate resistor (Rg) so that the discharge speed is reduced, in accordance with a magnitude of a negative potential generated at the first terminal due to an electromotive voltage of a wiring inductance;

    wherein the gate discharge current adjustment circuit (11) includes:

    a first resistor (R1) connected between the first terminal and the gate drive unit (21);
    a voltage source (VS) configured to supply the potential serving as the reference; and
    **characterized by** a series circuit including a second resistor (R2), and a capacitor (C1) which are connected in series in a freely-set order, and

    wherein the series circuit has one end connected to a node between the first resistor (R1) and the gate drive unit (21), and the other end connected to the voltage source (VS).

2. The gate drive circuit (31) according to claim 1,
    the series circuit including a first diode (D1) in series with the second resistor (R2) and the capacitor (C1) which are connected in series in a freely-set order, an anode terminal of the diode (D1) being connected to the voltage source and a cathode terminal of the diode (D1) being connected to the second resistor (R2).

3. The gate drive circuit (31) according to claim 2,

    wherein the semiconductor switch comprises a plurality of semiconductor switches, and
    wherein when the plurality of semiconductor switches form a half bridge, the voltage source (VS) is a gate drive power supply for a lower arm of the half bridge.

4. A power conversion device, comprising the gate drive circuit (31) of any one of claims 1 to 3.

## Patentansprüche

1. Gate-Ansteuerschaltung (31), umfassend:

    eine Gate-Ansteuereinheit (21), die so ausgelegt ist, dass sie eine Ein-/Aus-Steuerung eines Halbleiterschalters durchführt, der einen ersten Anschluss, einen zweiten Anschluss und einen Gate-Anschluss umfasst;
    einen Gate-Widerstand (Rg), der zwischen der Gate-Ansteuereinheit (21) und dem Gate-Anschluss angeschlossen ist; und
    eine Gate-Entladestrom-Einstellschaltung (11), die zwischen der Gate-Ansteuereinheit (21) und dem ersten Anschluss angeschlossen ist und so ausgelegt ist, dass sie, wenn die Gate-Ansteuereinheit (21) den Halbleiterschalter ausschaltet, eine Entladungsgeschwindigkeit, mit der Gate-Ladungen des Halbleiterschalters über den Gate-Widerstand (Rg) entladen werden, so ändert, dass die Entladungsgeschwindigkeit entsprechend der Größe eines negativen Potentials verringert wird, das am ersten Anschluss aufgrund einer elektromotorischen Spannung einer Verdrahtungsinduktivität erzeugt wird; wobei die Gate-Entladungsstrom-Einstellschaltung (11) umfasst:

einen ersten Widerstand (R1), der zwischen dem ersten Anschluss und der Gate-Ansteuereinheit (21) angeschlossen ist; eine Spannungsquelle (VS), die so ausgelegt ist, dass sie das als Referenz dienende Potential liefert; und **gekennzeichnet durch** eine Reihenschaltung, die einen zweiten Widerstand (R2) und einen Kondensator (C1) umfasst, die in einer frei wählbaren Reihenfolge in Reihe geschaltet sind, und wobei die Reihenschaltung mit einem Ende an einen Knotenpunkt zwischen dem ersten Widerstand (R1) und der Gate-Ansteuereinheit (21) angeschlossen ist und mit dem anderen Ende an die Spannungsquelle (VS) angeschlossen ist.

2. Gate-Ansteuerschaltung (31) nach Anspruch 1, wobei die Reihenschaltung eine erste Diode (D1) in Reihe mit dem zweiten Widerstand (R2) und dem Kondensator (C1) umfasst, die in einer frei wählbaren Reihenfolge in Reihe geschaltet sind, wobei ein Anodenanschluss der Diode (D1) mit der Spannungsquelle verbunden ist und ein Kathodenanschluss der Diode (D1) mit dem zweiten Widerstand (R2) verbunden ist.

3. Gate-Ansteuerschaltung (31) nach Anspruch 2,

wobei der Halbleiterschalter eine Vielzahl von Halbleiterschaltern umfasst, und wobei, wenn die Vielzahl von Halbleiterschaltern eine Halbbrücke bildet, die Spannungsquelle (VS) eine Gate-Ansteuerungs-Stromversorgung für einen unteren Zweig der Halbbrücke ist.

4. Eine Leistungsumwandlungsvorrichtung, die die Gate-Ansteuerschaltung (31) gemäß einem der Ansprüche 1 bis 3 umfasst.

**Revendications**

1. Circuit de commande de grille (31), comprenant :

une unité de commande de grille (21) configurée pour effectuer une commande de mise en marche/arrêt d'un commutateur à semi-conducteur comprenant une première borne, une deuxième borne et une borne de grille ; une résistance de grille (Rg) connectée entre l'unité de commande de grille (21) et la borne de grille ; et un circuit d'ajustement de courant de décharge de grille (11) qui est connecté entre l'unité de commande de grille (21) et la première borne, et qui est configuré pour modifier, lorsque l'unité de commande de grille (21) désactive le commutateur à semi-conducteur, une vitesse de décharge à laquelle des charges de grille du commutateur à semi-conducteur sont déchargées via la résistance de grille (Rg) de manière à réduire la vitesse de décharge, en fonction d'une amplitude d'un potentiel négatif généré au niveau de la première borne en raison d'une tension électromotrice d'une inductance de câblage ; dans lequel le circuit d'ajustement de courant de décharge de grille (11) comprend :

une première résistance (R1) connectée entre la première borne et l'unité de commande de grille (21) ; une source de tension (VS) configurée pour fournir le potentiel servant de référence ; et **caractérisé par** un circuit en série comprenant une deuxième résistance (R2) et un condensateur (C1) qui sont connectés en série dans un ordre librement défini, et dans lequel le circuit en série a une extrémité connectée à un nœud situé entre la première résistance (R1) et l'unité de commande de grille (21), et l'autre extrémité connectée à la source de tension (VS).

2. Circuit de commande de grille (31) selon la revendication 1, le circuit en série comprenant une première diode (D1) en série avec la deuxième résistance (R2) et le condensateur (C1) qui sont connectés en série dans un ordre librement défini, une borne d'anode de la diode (D1) étant connectée à la source de tension et une borne de cathode de la diode (D1) étant connectée à la deuxième résistance (R2).

**3.** Circuit de commande de grille (31) selon la revendication 2,

dans lequel le commutateur à semi-conducteur comprend une pluralité de commutateurs à semi-conducteur, et dans lequel, lorsque la pluralité de commutateurs à semi-conducteur forme un demi-pont, la source de tension (VS) est une alimentation électrique de commande de grille pour un bras inférieur du demi-pont.

**4.** Dispositif de conversion de puissance, comprenant le circuit de commande de grille (31) selon l'une quelconque des revendications 1 à 3.

**FIG. 1**

**FIG. 2**

FIG. 3

FIG. 4

FIG. 5

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001045740 A
- WO 2016205929 A1
- US 2018159522 A1
- US 4947063 A